# EUROPÄISCHE PATENTSCHRIFT

(11) **EP 1 697 980 B1**
(45) Veröffentlichungstag und Bekanntmachung des Hinweises auf die Patenterteilung: **12.08.2009**
(21) Anmeldenummer: 04803007.6
(22) Anmeldetag: 22.12.2004
(51) Int. Cl.: H01L 21/306, F26B 3/30

(54) **VERFAHREN UND VORRICHTUNG ZUR TROCKNUNG VON SCHALTUNGSSUBSTRATEN**
METHOD AND DEVICE FOR DRYING CIRCUIT SUBSTRATES
PROCEDE ET DISPOSITIF POUR SECHER DES SUBSTRATS DE CIRCUITS

(30) Priorität: 22.12.2003 DE 10361075
(43) Veröffentlichungstag der Anmeldung: 06.09.2006
(73) Patentinhaber: Pac Tech - Packaging Technologies GmbH, 14641 Nauen (DE)
(72) Erfinder: ZAKEL, Elke, 14612 Falkensee (DE); AZDASHT, Ghassem, 14052 Berlin (DE)
(74) Vertreter: Tappe, Hartmut
(86) Internationale Anmeldenummer: PCT/DE2004/002827
(87) Internationale Veröffentlichungsnummer: WO 2005/062358

(56) Entgegenhaltungen:
- US-A- 5 556 479
- US-A- 6 128 829
- PATENT ABSTRACTS OF JAPAN Bd. 2002, Nr. 09, 4. September 2002 (2002-09-04) & JP 2002 134463 A (DAINIPPON SCREEN MFG CO LTD), 10. Mai 2002 (2002-05-10)
- PATENT ABSTRACTS OF JAPAN Bd. 1999, Nr. 03, 31. März 1999 (1999-03-31) & JP 10 321583 A (KAIJO CORP), 4. Dezember 1998 (1998-12-04)

## Beschreibung

Die vorliegende Erfindung betrifft ein Verfahren zur Trocknung von Schaltungssubstraten nach dem Oberbegriff des Patentanspruchs 1. Des weiteren betrifft die Erfindung eine Vorrichtung zur Durchführung des vorstehenden Verfahrens.

Insbesondere Halbleiterwafer, die zur Herstellung von Chips dienen, werden vor ihrer Vereinzelung in Chips mit einem die spätere Kontaktierung der Chips ermöglichenden Anschlussflächenaufbau versehen, der die Ausbildung von geeigneten Kontaktmetallisierungen auf den Anschlussflächen umfasst. Hierzu werden regelmäßig chemische Abscheidungstechniken verwendet, die einen schichtweisen Aufbau der Kontaktmetallisierungen ermöglichen. Insbesondere zur Vermeidung einer Korrosion auf den kontaktseitigen Oberflächen der Wafer bzw. der daraus durch Vereinzelung erzeugten Chips ist es notwendig, eine Reinigung der Anschluss- oder Schaltungsoberfläche vorzunehmen, bei der die Oberfläche verunreinigende, durch die Abscheidungsvorgänge verursachte ionische oder anionische Kontaminationen entfernt werden. Hierzu ist es bekannt, die Anschlussoberfläche der Halbleitersubstrate wiederholt mit deionisiertem Wasser so lange zu spülen, bis nur noch eine zulässige Ionenkonzentration im Spülwasser messbar ist.

Es hat sich nun gezeigt, dass im Falle einer dem Spülvorgang nachfolgenden Trocknung der Anschlussoberfläche nach Verdunstung auf der Anschlussoberfläche verbliebener Spülwasserrückstände Korrosionsnester auf der Anschlussoberfläche verbleiben.

In der Vergangenheit sind daher verschiedene Anstrengungen unternommen worden, um dem Spülvorgang unmittelbar nachfolgend eine möglichst rückstandsfreie Trocknung der Anschlussoberfläche zu ermöglichen. Eine dieser Möglichkeiten besteht darin, das Schaltungssubstrat nach Beaufschlagung mit Spülflüssigkeit oder nach Entnahme aus einem Spülbad mit Temperatur zu beaufschlagen, um ein möglichst schnelles und rückstandsfreies Verdampfen des Spülwassers zu ermöglichen. Nachteilig hiermit verbunden ist jedoch, dass die mit der bekannten Trocknung einhergehende Temperaturbelastung häufig in den Bereich der für die einwandfreie Funktion des Schaltungssubstrats noch gerade zulässigen Temperaturbelastung gelangt oder diesen sogar überschreitet. Des Weiteren ist auch bekannt, durch verschiedene Maßnahmen die Oberflächenspannung des Wassers zu reduzieren, um ein schnelleres und möglichst rückstandsfreies Abfließen des Spülwassers von der Schaltungsoberfläche zu ermöglichen. Jedoch ist festzustellen, dass die beispielsweise hierbei zum Einsatz kommenden Tenside als Zugabe zum Spülwasser regelmäßig ihrerseits wieder Rückstände auf der Anschlussoberfläche bewirken. Derartige Rückstände lassen sich zwar bei einer Reinigung unter Zugabe von Alkohol vermeiden, jedoch macht die Verwendung von Alkohol als Spülflüssigkeit die ergänzende Verwendung häufig explosiver Stoffe notwendig, so dass die Durchführung derartiger Verfahren einen besonderen Explosionsschutz erforderlich macht und damit entsprechend kostenaufwendig ist.

Aus der US 6,128,829 ist ein Verfahren zur Trocknung eines Schaltungssubstrats bekannt, bei dem an Oberflächen des Schaltungssubstrats Flüssigkeitsmenisken ausgebildet werden, wobei eine unmittelbare

Beaufschlagung der Flüssigkeitsmenisken mit Wärmestrahlung erfolgt. Eine Wärmestrahlereinrichtung ist hier aus einem Mikrowellenlaser mit einer Fokussiereinrichtung, welche eine Fokussierung der Strahlungsenergie auf einen Flüssigkeitsmeniskus ermöglicht, gebildet.

Eine Vorrichtung und ein Verfahren zur Trocknung eines Schaltungssubstrats ist aus der US 5,556,479 bekannt, wobei ein Badbehälter der Vorrichtung zur Aufnahme eines Schaltungssubstrats mit einer Zuflusseinrichtung und einer Abflusseinrichtung versehen ist. Ein Flüssigkeitsspiegel ist entlang des Schaltungssubstrats absenkbar, wobei das Schaltungssubstrat vermittels einer Wärmestrahlereinrichtung, welche das Schaltungssubstrat parallel zum Flüssigkeitsspiegel mit Wärmestrahlung beaufschlägt, trockenbar ist.

Der vorliegenden Erfindung liegt die Aufgabe zugrunde, ein Verfahren bzw. eine Vorrichtung zur Durchführung eines Verfahrens vorzuschlagen, das bzw. die eine gleichzeitige Beaufschlagung einer Mehrzahl von Schaltungssubstraten mit Wärmeenergie für eine im Wesentlichen rückstandsfreie Reinigung ohne einen zu hohen Aufwand bei Durchführung des Verfahrens bzw. Betrieb der entsprechenden Vorrichtung ermöglicht.

Die vorstehende Aufgabe wird durch ein Verfahren gemäß dem Anspruch 1 bzw. eine Vorrichtung gemäß dem Anspruch 6 gelöst.

Bei dem erfindungsgemäßen Verfahren, bei dem in einem Spülgang ein Spülen einer Schaltungsoberfläche des Schaltungssubstrats mit einer Spülflüssigkeit erfolgt und in einem nachfolgenden Trocknungsgang die Schaltungsoberfläche getrocknet wird, wird das Schaltungssubstrat im Spülgang in Richtung seiner ebenen Erstreckung, quer und relativ zu einem Flüssigkeitsspiegel der Spülflüssigkeit, bewegt, derart, dass sich an einem sich aufgrund der Relativbewegung ändernden Übergangsbereich zwischen der Schaltungsoberfläche und dem Flüssigkeitsspiegel ein Flüssigkeitsmeniskus ausbildet und im Trocknungsgang eine Beaufschlagung des von dem Flüssigkeitsmeniskus benetzten Übergangsbereichs mit Wärmestrahlung quer zum Flüssigkeitsspiegel mittels einer oberhalb einer Aufnahmeanordnung angeordneten Wärmestrahleneinrichtung erfolgt.

Bei Anwendung des erfindungsgemäßen Verfahrens wird das Schaltungssubstrat in einem mit dem Flüssigkeitsmeniskus benetzten Übergangsbereich mit Wärmestrahlung beaufschlagt, so dass mittels einer Absorption der Wärmestrahlung im Schaltungssubstrat eine eine Verdampfung bewirkende Temperaturerhöhung des Flüssigkeitsmeniskus erfolgt. Da während der Temperaturbeaufschlagung ein sich zwar verändernder, jedoch stets mehr oder weniger großer Teil des Schaltungssubstrats im Flüssigkeitsbad verbleibt, erfolgt stets parallel zur Temperaturbeaufschlagung eine Wärmeabfuhr vom Schaltungssubstrat in das Flüssigkeitsbad, so dass eine Überhitzung des Substrats weitestgehend ausgeschlossen werden kann. Darüber hinaus ermöglicht die Temperaturbeaufschlagung durch Wärmestrahlung ein im Wesentlichen konvektionsfreies Erwärmen des Schaltungssubstrats, so dass eine Kontamination durch in einer Konvektionsströmung mitgeführte Verunreinigungen weitestgehend ausgeschlossen werden kann.

Gemäß einer bevorzugten Variante des Verfahrens erfolgt die Beaufschlagung mit Wärmestrahlung mittels eines Infrarot-Strahlers, so dass ein besonders effektiver Wärmeeintrag in das Schaltungssubstrat ermöglicht wird.

Eine insbesondere hinsichtlich des benötigten Raumbedarfs bei Durch-, führung des Verfahrens vorteilhafte Variante besteht darin, dass zur Ausführung der Relativbewegung zwischen dem Flüssigkeitsspiegel und dem Schaltungssubstrat das Schaltungssubstrat in der von einem Badbehälter aufgenommenen Spülflüssigkeit angeordnet und der Flüssigkeitsspiegel abgesenkt wird.

Wenn die Beaufschlagung mit Wärmestrahlung quer zum Flüssigkeitsspiegel erfolgt, ist es möglich, gleichzeitig eine Mehrzahl in einer Verbundanordnung angeordneter Schaltungssubstrate mit der Wärmestrahlung zu beaufschlagen.

Darüber hinaus erweist es sich als besonders vorteilhaft, wenn im Wesentlichen parallel zum Flüssigkeitsspiegel eine Belüftung eines oberhalb des Flüssigkeitsspiegels ausgebildeten Behälterlumens erfolgt, da somit ein nachfolgendes Kondensieren der im Bereich des Flüssigkeitsmeniskus verdampften Flüssigkeit auf dem Schaltungssubstrat verhindert werden kann.

Wenn vor Durchführung des Trocknungsgangs in dem Badbehälter durch wiederholtes Fluten des Behälters eine Mehrzahl von Spülgängen durchgeführt wird, ermöglicht das Verfahren nicht nur einen abschließenden Reinigungsteilschritt betreffend die rückstandsfreie Trocknung der Anschlussoberflächen von Schaltungssubstraten, sondern darüber hinaus auch die Durchführung einer vorhergehenden Mehrzahl von Spülvorgängen mit dem Ziel, die Ionen- bzw. Anionenkonzentration auf den Schaltungsoberflächen vor dem nachfolgenden Trocknungsgang in einem insgesamt kontinuierlichen Verfahren in einer einzigen Vorrichtung vorzunehmen.

Die erfindungsgemäße Vorrichtung zur Durchführung des Verfahrens zur Trocknung von Schaltungssubstraten, insbesondere Halbleitersubstraten, ist mit einem Badbehälter versehen, der über eine Zuflusseinrichtung und eine Abflusseinrichtung verfügt und in dem eine Aufnahmeanordnung zur Aufnahme zumindest eines Schaltungssubstrats angeordnet ist, derart, dass sich das Schaltungssubstrat in einer Ebene in Richtung auf einen Behälterboden erstreckt. Darüber hinaus ist die erfindungsgemäße Vorrichtung mit einer eine Behälteröffnung des Badbehälters verschließenden Deckeleinrichtung und mit einer oberhalb der Aufnahmeanordnung angeordneten Wärmestrahlereinrichtung versehen.

In einer besonders vorteilhaften Ausführungsform der Vorrichtung ist die Wärmestrahlereinrichtung mit Infrarot-Strahlern versehen.

Wenn die Wärmestrahlereinrichtung an der Deckeleinrichtung angeordnet ist, ist eine einfache Anordnung der Wärmestrahlereinrichtung oberhalb des Flüssigkeitsspiegels möglich, die eine gleichzeitige Beaufschlagung einer Mehrzahl von in der Aufnahmeanordnung aufgenommenen Schaltungssubstraten ermöglicht.

Weiterhin ist es vorteilhaft, wenn zur Abtrennung von einem Behälterinnenraum der Wärmestrahler oberhalb einer transparenten Platte angeordnet ist, so dass der Wärmestrahler selbst geschützt außerhalb der aggressiven Atmosphäre im Behälterinnenraum angeordnet ist.

Wenn der Badbehälter im Bereich der Deckeleinrichtung mit einer Belüftungseinrichtung versehen ist, lässt sich die Effektivität der Vorrichtung noch weiter erhöhen. Besonders vorteilhaft für eine einfache Gestaltung der Vorrichtung ist es, wenn die Belüftungseinrichtung an der Deckeleinrichtung angeordnet ist.

Nachfolgend wird eine bevorzugte Variante des erfindungsgemäßen Verfahrens sowie eine hierzu bevorzugt verwendbare Vorrichtung anhand der Zeichnungen näher erläutert.

### Es zeigen:

- **Fig.1**: ne Schnittdarstellung einer Vorrichtung zur Reinigung von Halbleitersubstraten;
- **Fig. 2**: eine vergrößerte Darstellung eines zwischen einem Flüssigkeitsspiegel und einer Schaltungsoberfläche des Halbleitersubstrats ausgebildeten Flüssigkeitsmeniskus.

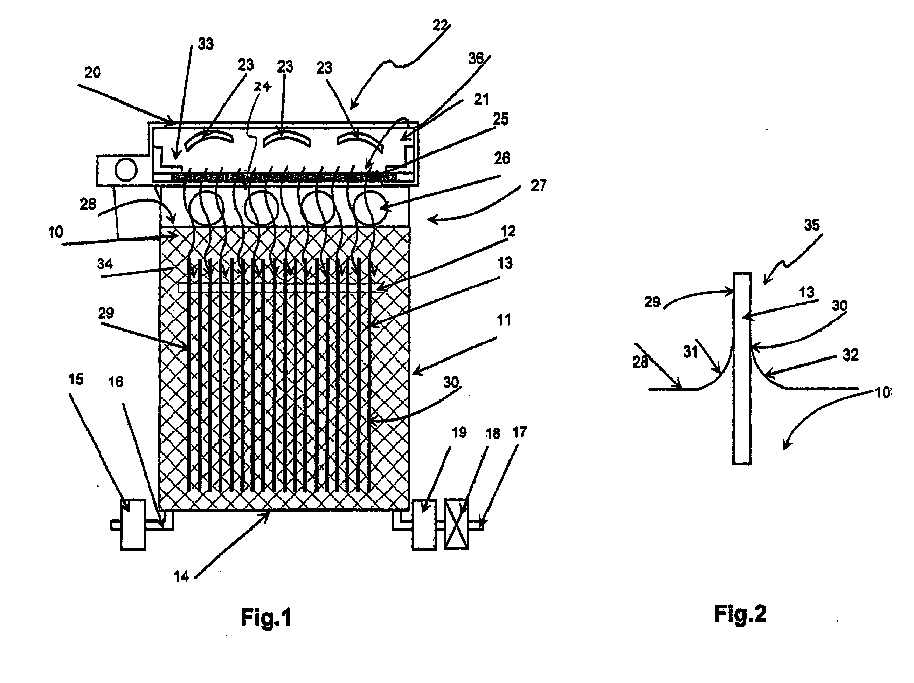

**Fig. 1** zeigt einen mit einer Spülflüssigkeit 10, die im vorliegenden Fall aus deionisiertem Wasser gebildet ist, gefüllten Badbehälter 11, in dem eine Aufnahmeanordnung 12 mit darin gleichmäßig verteilt aufgenommenen Wafern 13 angeordnet ist. Die Aufnahmeanordnung 12 kann beispielsweise zwei die Wafer 13 am Umfangsrand zwischen sich aufnehmende Klemmbacken aufweisen, so dass die Waferoberflächen frei zugänglich bleiben.

Der Badbehälter 11 ist im Bereich seines Behälterbodens 14 mit einer mit einem Einlassventil 15 versehenen Zuflusseinrichtung 16 versehen. Weiterhin ist im Bereich des Behälterbodens 14 eine Abflusseinrichtung 17 vorgesehen, die ein Auslassventil 18 aufweist. Darüber hinaus ist die Abflusseinrichtung 17 mit einem Strömungsventil 19 ausgestattet, dass eine Einstellung der Ausströmgeschwindigkeit der durch die Abflusseinrichtung 17 ausströmenden Spülflüssigkeit 10 ermöglicht.

Im Bereich der dem Behälterboden 14 gegenüberliegend angeordneten Behälteröffnung 24 des Badbehälters 11, die ein Einsetzen und Herausnehmen der in der Aufnahmeanordnung 12 angeordneten Wafer 13 ermöglicht, ist eine die Behälteröffnung 24 verschließende Deckeleinrichtung 20 angeordnet, die einen Betrieb des Badbehälters 11 als eine gegenüber der Umgebung abgeschlossene Prozesskammer ermöglicht.

Die Deckeleinrichtung 20 ist im vorliegenden Fall gehäuseartig mit einem Deckelinnenraum 21 ausgebildet, in dem eine Wärmestrahlereinrichtung 22 mit im vorliegenden Fall eine Mehrzahl von Infrarot-Strahlern umfassenden Wärmestrahlern 23 aufgenommen ist. Zur Vermeidung eines Wärmestaus kann die Deckeleinrichtung 20 mit einer hier nicht näher dargestellten Belüftung versehen sein. Eine unmittelbar gegenüberliegend der Behälteröffnung 24 angeordnete Deckelwandung 25 ist transparent und im vorliegenden Fall als eine in die Deckeleinrichtung 20 eingesetzte Glasplatte 25 ausgebildet. Benachbart der Behälteröffnung 24 und oberhalb eines Flüssigkeitsspiegels 28 des in Fig. 1 im vollständig gefluteten Zustand dargestellten Badbehälters 11 angeordnet befindet sich eine mehrere parallel zur Ebene der Behälteröffnung 24 verlaufende Belüftungskanäle 26 aufweisende Belüftungseinrichtung 27. Die Belüftungskanäle 26 münden im vorliegenden Fall von außen in eine rückwärtige Behälterwandung 34 des Badbehälters 11 und ermöglichen eine Zuführung und Abführung einer parallel zum Flüssigkeitsspiegel 28 gerichteten Belüftungsströmung mit sehr geringer Strömungsgeschwindigkeit.

Zum Betrieb der in Fig. 1 dargestellten Vorrichtung wird die Aufnahmeanordnung 12 mit den darin aufgenommenen Wafern 13 in den Badbehälter 11 eingesetzt und der Badbehälter 11 mittels der Deckeleinrichtung 20 verschlossen. In einem anschließenden Befüllungsvorgang wird der Badbehälter 11 bei geschlossenem Auslassventil 18 der Abflusseinrichtung 17 durch die Zuflusseinrichtung 16 mit Spülflüssigkeit 10 bis zum Erreichen eines in Fig. 1 dargestellten Flüssigkeitsspiegels 28, der die sich zum Behälterboden 14 hin erstreckenden Wafer 13 vollständig abdeckt, mit Spülflüssigkeit 10 geflutet.

Ausgehend von dem in **Fig. 1** dargestellten gefluteten Zustand des Badbehälters 11 wird nun bei geöffnetem Strömungsventil 19 der Flüssigkeitsspiegel 28 vorzugsweise kontinuierlich abgesenkt, so dass ein fortschreitend größer werdender Teil der Wafer 13 aus der Spülflüssigkeit 10 herausragt. Während des Absenkens des Flüssigkeitsspiegels 28 bildet sich in einem Übergangsbereich 35 zwischen den quer zum Flüssigkeitsspiegel 28 verlaufenden Oberflächen 29, 30 der Wafer 13 und dem Flüssigkeitsspiegel 28 ein Flüssigkeitsmeniskus 31, 32 aus, wie in **Fig. 2** dargestellt. Zumindest eine der Oberflächen 29, 30 ist als Schaltungsoberfläche mit darauf angeordneten Kontaktmetallisierungen ausgebildet.

Während des Absenkens des Flüssigkeitsspiegels 28 ist die im vorliegenden Ausführungsbeispiel IR- Strahlung emittierende Wärmestrahlereinrichtung 22 mit den durch die Glasplatte 25 vom Flüssigkeitsspiegel 28 abgetrennten Wärmestrahlern 23 in Betrieb. In Folge der Absorption der Wärmestrahlung 36 im Halbleitermaterial der Wafer 13 erfolgt eine Erwärmung des oberhalb des Flüssigkeitsspiegels 28 angeordneten Teils der Wafer 13, wohingegen der in der Spülflüssigkeit 10 angeordnete Teil der Wafer 13 durch den Wärmeübergang zwischen dem Halbleitermaterial und der Spülflüssigkeit 10 relativ gekühlt wird. Hierdurch wird verhindert, dass es trotz einer für ein Verdampfen der Spülflüssigkeit 10 im Bereich der Flüssigkeitsmenisken 31, 32 ausreichenden Erwärmung des Halbleitermaterials zu einer die Funktion des Wafers beeinträchtigenden Überhitzung des Halbleitermaterials kommen kann. Durch die Verdampfung der Spülflüssigkeit 10 im Bereich der Flüssigkeitsmenisken 31, 32 wird sichergestellt, dass im Wesentlichen keine Reste von Spülflüssigkeit auf den Oberflächen 29, 30 der Wafer 13 verbleiben. Neben dem Verdampfen der Spülflüssigkeit im Bereich der Flüssigkeitsmenisken 31, 32 wird durch die Erwärmung des Halbleitermaterials im Bereich der Flüssigkeitsmenisken 31, 32 auch die Oberflächenspannung der Flüssigkeitsmenisken reduziert, so dass die Benetzungseigenschaften der Spülflüssigkeit 10 im Bereich der Oberflächenmenisken 31, 32 vergrößert werden und ein besseres Ablaufen der Spülflüssigkeit 10 von den Oberflächen 29, 30 erreicht wird.

Der im Wesentlichen auf den Grenzbereich zwischen den Oberflächen 29, 30 des Wafers 13 und den Flüssigkeitsmenisken 31, 32 beschränkte Wärmeübergang sorgt dafür, dass eine Erwärmung und damit verbundene Reduzierung der Oberflächenspannung der Spülflüssigkeit nur im vorgenannten Grenzbereich auftritt, so dass daran angrenzend die Oberflächenspannung der Spülflüssigkeit im Wesentlichen erhalten bleibt und verhindert wird, dass es im Bereich der Flüssigkeitsmenisken 31, 32 zu einer Tropfenbildung kommt. Unterstützt wird dieser vorteilhafte Effekt noch durch die Wahl einer Absinkgeschwindigkeit des Flüssigkeitsspiegels 28, die eine zur Erzielung der vorgenannten Effekte ausreichende Kontaktzeit zwischen den Oberflächen 29, 30 des Wafers 13 und den Flüssigkeitsmenisken 31, 32 ermöglicht.

Ausgehend von dem in **Fig. 1** dargestellten gefluteten Zustand des Badbehälters 11 wird bei einem Absenken des Flüssigkeitsspiegels 28 ein zwischen dem Flüssigkeitsspiegel 28 und der Glasplatte 25 gebildetes Lumen 33 stetig größer. Um zu verhindern, dass in Folge der Beaufschlagung mit Wärmestrahlung 36 verdampfte Spülflüssigkeit 10 nach einem Abkühlen wieder oberhalb des Flüssigkeitsspiegels 28 an den Oberflächen 29, 30 der Wafer 13 kondensiert, erfolgt durch die Belüftungseinrichtung 27 eine Belüftung des Lumens 33.

## Patentansprüche

**1.** Verfahren zur Trocknung von Schaltungssubstraten (13), insbesondere Halbleitersubstraten, bei dem in einem Spülgang ein Spülen einer Schaltungsoberfläche (29, 30) des in einer Aufnahmeanordnung (12) aufgenommenen Schaltungssubstrats mit einer Spülflüssigkeit (10) erfolgt und in einem nachfolgenden Trocknungsgang die Schaltungsoberfläche getrocknet wird, wobei in dem Spülgang das Schaltungssubstrat in Richtung seiner ebenen Erstreckung, quer und relativ zu einem Flüssigkeitsspiegel (28) der Spülflüssigkeit, bewegt wird, derart, dass sich an einem sich aufgrund der Relativbewegung ändernden Übergangsbereich (35) zwischen der Schaltungsoberfläche und dem Flüssigkeitsspiegel ein Flüssigkeitsmeniskus (31, 32) ausbildet, und in dem Trocknungsgang eine Beaufschlagung des von dem Flüssigkeitsmeniskus benetzten Übergangsbereichs mit Wärmestrahlung (36) mittels einer Wärmestrahlereinrichtung (22) erfolgt,
**dadurch gekennzeichnet,**
**dass** die Beaufschlagung mit Wärmestrahlung mittels der sowohl oberhalb der Aufnahmeanordnung (12) als auch oberhalb des Schaltungssubstrats angeordneten Wärmestrahlereinrichtung erfolgt.

**2.** Verfahren nach Anspruch 1,
**dadurch gekennzeichnet,**
**dass** die Beaufschlagung mit Wärmestrahlung (36) mittels eines Infrarot-Strahlers erfolgt.

**3.** Verfahren nach Anspruch 1 oder 2,
**dadurch gekennzeichnet,**
**dass** zur Ausführung der Relativbewegung zwischen dem Flüssigkeitsspiegel (28) und dem Schaltungssubstrat (13) das Schaltungssubstrat in der von einem Badbehälter (11) aufgenommenen Spülflüssigkeit (10) angeordnet und der Flüssigkeitsspiegel abgesenkt wird.

**5.** Verfahren nach einem der vorangehenden Ansprüche,
**dadurch gekennzeichnet,**
**dass** vor Durchführung des Trocknungsgangs in dem Badbehälter (11) durch wiederholtes Fluten des Badbehälters eine Mehrzahl von Spülgängen durchgeführt wird.

**4.** Verfahren nach einem der vorangehenden Ansprüche,
**dadurch gekennzeichnet,**
**dass** die Beaufschlagung mit Wärmestrahlung (36) quer zum Flüssigkeitsspiegel (28) erfolgt.

**6.** Vorrichtung zur Durchführung eines Verfahrens zur Trocknung von Schaltungssubstraten (13), insbesondere Halbleitersubstraten, nach einem oder mehreren der Ansprüche 1 bis 5, mit einem mit einer Zuflusseinrichtung (16) und einer Abflusseinrichtung (17) versehenen und mit einer Deckeleinrichtung (20) verschließbaren Badbehälter (11) und einer im Badbehälter angeordneten Aufnahmeanordnung (12) zur Aufnahme zumindest eines Schaltungssubstrats, derart, dass sich das Schaltungssubstrat in einer Ebene in Richtung auf einen Behälterboden (14) erstreckt, sowie mit einer Wärmestrahlereinrichtung (22)
**dadurch gekennzeichnet,**
**dass** die Wärmestrahlereinrichtung oberhalb der Aufnahmeanordnung angeordnet ist, derart, dass eine gleichzeitige Beaufschlagung einer Mehrzahl von in der Aufnahmeanordnung aufgenommenen Schaltungssubstraten möglich ist.

**7.** Vorrichtung nach Anspruch 6,
**dadurch gekennzeichnet,**
**dass** die Wärmestrahlereinrichtung (22) mit Infrarot-Strahlern versehen ist.

**8.** Vorrichtung nach Anspruch 6 oder 7,
**dadurch gekennzeichnet,**
**dass** die Wärmestrahlereinrichtung (22) an der Deckeleinrichtung (20) angeordnet ist.

**9.** Vorrichtung nach einem oder mehreren der Ansprüche 6 bis 8,
**dadurch gekennzeichnet,**
**dass** zur Abtrennung von einem Behälterinnenraum die Wärmestrahlereinrichtung (22) oberhalb einer transparenten Platte (25) angeordnet ist.

**10.** Vorrichtung nach einem der Ansprüche 6 bis 9,
**dadurch gekennzeichnet,**
**dass** der Badbehälter (11) im Bereich der Deckeleinrichtung (20) mit einer Belüftungseinrichtung (27) versehen ist.

**11.** Vorrichtung nach Anspruch 10,
**dadurch gekennzeichnet,**
**dass** die Belüftungseinrichtung (27) an der Deckeleinrichtung (20) angeordnet ist.

## Claims

1. A method for drying circuit substrates (13), in particular semiconductor substrates, in which a circuit surface (29, 30) of the circuit substrate received in a receiving system (12) is flushed using a flushing liquid (10) in a flushing step and the circuit surface is dried in a subsequent drying step, the circuit substrate being moved in the flushing step in the direction of its planar extension transversely and in relation to a liquid level (28) of the flushing liquid in such way that a liquid meniscus (31, 32) forms at a transition area (35) between the circuit surface and the liquid level, which changes because of the relative movement, and thermal radiation (36) is applied to the transition area wetted by the liquid meniscus in the drying step using a thermal radiator unit (22),
**characterized in that**
thermal radiation is applied using the thermal radiator unit which is situated both above the receiving system (12) and above the circuit substrate.

2. The method according to Claim 1,
**characterized in that**
thermal radiation (36) is applied using an infrared radiator.

3. The method according to Claim 1 or 2,
**characterized in that**
to perform the relative movement between the liquid level (28) and the circuit substrate (13), the circuit substrate is situated in the flushing liquid (10) received by a bath container (11) and the liquid level is lowered.

4. The method according to one of the preceding claims,
**characterized in that**
thermal radiation (36) is applied transversely to the liquid level (28).

5. The method according to one of the preceding claims,
**characterized in that**
multiple flushing steps are performed in the bath container (11) through repeated flooding of the bath container before performing the drying step.

6. A device for performing a method for drying circuit substrates (13), in particular semiconductor substrates, according to one or more of Claims 1 through 5, having a bath container (11), which is provided with an inflow unit (16) and an outflow unit (17) and is closable using a cover unit (20), and a receiving system (12), which is situated in the bath container, for receiving at least one circuit substrate in such a way that the circuit substrate extends in a plane in the direction of a container floor (14), and having a thermal radiator unit (22)
**characterized in that**
the thermal radiator unit is situated above the receiving system so as to allow simultaneous application to multiple circuit substrates
received in the receiving system.

7. The device according to Claim 6,
**characterized in that**
the thermal radiator unit (22) is provided with infrared radiators.

8. The device according to Claim 6 or 7,
**characterized in that**
the thermal radiator unit (22) is situated on the cover unit (20).

9. The device according to one or more of Claims 6 through 8,
**characterized in that**
the thermal radiator unit (22) is situated above a transparent plate (25) for separation from a container interior.

10. The device according to one of Claims 6 through 9,
**characterized in that**
the bath container (11) is provided in the area of the cover unit (20) with a ventilation unit (27).

11. The device according to Claim 10,
**characterized in that**
the ventilation unit (27) is situated on the cover unit (20).

## Revendications

1. Procédé de séchage de substrats de circuits (13), notamment de substrats semi-conducteurs, dans lequel à une étape de rinçage un rinçage d'une surface de circuit (29,30) du substrat de circuit renfermé dans un agencement de réceptacle (12) est effectué avec un liquide de rinçage (10) et à une étape de séchage consécutive, la surface du substrat est séchée, moyennant quoi à l'étape de rinçage le substrat de circuit est déplacé dans la direction de son extension planaire, transversalement et relativement à un niveau de liquide (28) du liquide de rinçage, de telle sorte que un ménisque de liquide (31,32) soit réalisé sur une zone de transition (35) variant du fait du mouvement relatif entre la surface de circuit et le niveau de liquide et à l'étape de séchage une sollicitation de la zone de transition mouillée par le ménisque de liquide soit effectuée par un rayonnement thermique (36) au moyen d'un dispositif de rayonnement thermique (22),
**caractérisé en ce que**
la sollicitation avec un rayonnement thermique s'effectue au moyen du dispositif de rayonnement thermique disposé tant au dessus de l'agencement de réceptacle (12) que au dessus du substrat de circuit.

2. Procédé selon la revendication 1,
**caractérisé en ce que**
la sollicitation par un rayonnement thermique (36) s'effectue au moyen d'un émetteur de rayonnement infrarouge.

3. Procédé selon la revendication 1 ou 2,
**caractérisé en ce que**
pour exécuter le mouvement relatif entre le niveau de liquide (28) et le substrat de circuit (13), le substrat de circuit est disposé dans le liquide de rinçage (10) renfermé par un récipient de bain (11) et le niveau de liquide est baissé.

4. Procédé selon une des revendications précédentes,
**caractérisé en ce que**
la sollicitation par un rayonnement thermique (36) s'effectue transversalement au niveau de liquide (28).

5. Procédé selon une des revendications précédentes,
**caractérisé en ce que**
avant d'exécuter l'étape de séchage dans le récipient de bain (11), une pluralité d'étapes de rinçage sont exécutées en immergeant répétitivement le récipient de bain.

6. Dispositif pour mettre en oeuvre le procédé de séchage de substrats de circuits (13), notamment de substrats semi-conducteurs, selon une ou plusieurs des revendications 1 à 5, comportant un récipient de bain (11) pourvu d'un dispositif d'amenée de liquide (16) et un dispositif d'évacuation de liquide (17) et pouvant être fermé par un dispositif de couvercle (20) et un agencement de réceptacle (12) disposé dans le récipient de bain afin de recevoir au moins un substrat de circuit, de telle sorte que le substrat de circuit s'étende dans un plan dans la direction d'un fond de récipient (14), ainsi que comportant un dispositif de rayonnement thermique (22),
**caractérisé en ce que**
le dispositif de rayonnement thermique est disposé au dessus de l'agencement de réceptacle, de telle sorte qu' une sollicitation simultanée d'une pluralité de substrats de circuits renfermés dans l'agencement de réceptacle soit possible.

7. Dispositif selon la revendication 6,
**caractérisé en ce que**
le dispositif de rayonnement thermique (22) est pourvu d'émetteurs de rayonnement infrarouge.

8. Dispositif selon la revendication 6 ou 7,
**caractérisé en ce que**
le dispositif de rayonnement thermique (22) est disposé sur le dispositif de couvercle (20).

9. Dispositif selon une ou plusieurs des revendications 6 à 8,
**caractérisé en ce que**
à des fins d'isolation d'un espace interne de récipient, le dispositif de rayonnement thermique (22) est disposé au dessus d'une plaque transparente (25).

10. Dispositif selon une des revendications 6 à 9,
**caractérisé en ce que**
le récipient de bain (11) est pourvu au niveau du dispositif de couvercle (20) d'un dispositif d'aération (27).

11. Dispositif selon la revendication 10,
**caractérisé en ce que**
le dispositif d'aération (27) est disposé sur le dispositif de couvercle (20).
